# FASCICULE DE BREVET EUROPEEN

(11) **EP 0 645 892 B1**
(45) Date de publication et mention de la délivrance du brevet: **13.01.1999**
(21) Numéro de dépôt: 94402081.7
(22) Date de dépôt: 19.09.1994
(51) Int. Cl.: H03L 7/191

(54) **Dispositif d'asservissement de fréquence**
Frequenzregelkreis
Frequency-locked loop

(30) Priorité: 28.09.1993 FR 9311633
(43) Date de publication de la demande: 29.03.1995
(73) Titulaire: FRANCE TELECOM, 75015 Paris (FR); TELEDIFFUSION DE FRANCE, société anonyme, 75015 Paris (FR)
(72) Inventeur: Bauduin, Jean-Pierre, F-35270 Combourg (FR)
(74) Mandataire: Cabinet Martinet & Lapoux

(56) Documents cités:
- DE-A- 2 456 742
- US-A- 4 743 857

## Description

La présente invention concerne de manière générale un dispositif pour asservir une fréquence d'un signal d'horloge local à N fois la fréquence d'un signal d'horloge pilote, N étant un entier prédéterminé.

Typiquement, un tel dispositif d'asservissement de la fréquence d'un signal d'horloge local est utilisé lors d'une phase de maintien en fréquence succédant à une phase d'acquisition en fréquence. La fréquence du signal d'horloge local égale à N fois la fréquence du signal d'horloge pilote est acquise lors de la phase d'acquisition et cette fréquence acquise est maintenue par le dispositif d'asservissement de fréquence.

L'invention trouve application notamment dans le domaine des télécommunications pour asservir la fréquence d'un signal d'horloge local d'échantillonnage dans un système de réception à N fois la fréquence d'un signal d'horloge pilote reçu par ce système. La fréquence du signal d'horloge pilote est par exemple la fréquence de trames de données reçues par le système de réception. Dans cet exemple, le signal d'horloge local a une fréquence égale à la fréquence des éléments binaires dans chaque trame, N étant alors égal au nombre d'éléments binaires dans une trame. Un tel exemple d'application de l'invention permet de récupérer la fréquence des éléments binaires dans chaque trame à partir de la fréquence de trame, afin d'échantillonner ces éléments binaires et ainsi retrouver les données incluses dans les trames.

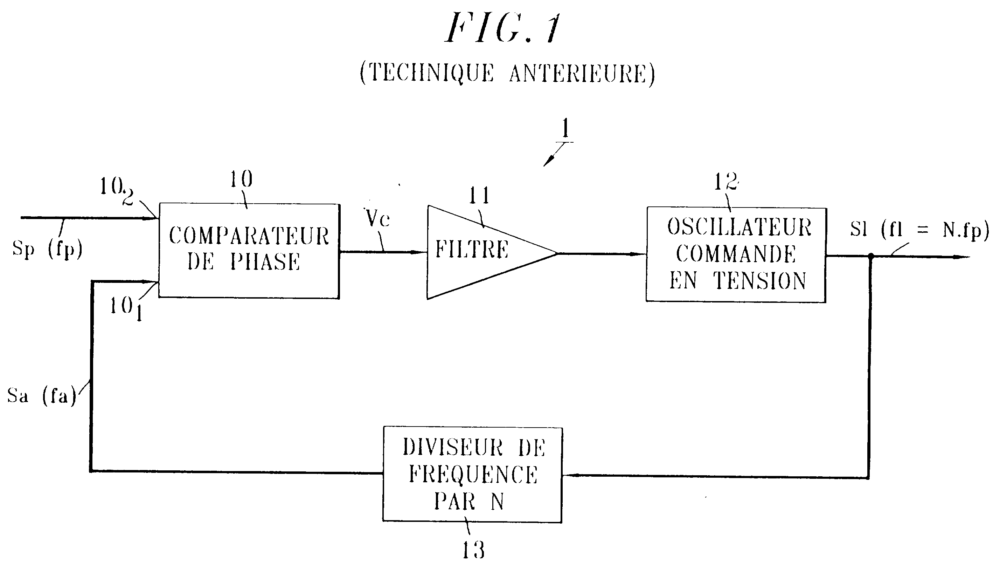

La figure 1 est un bloc-diagramme d'un dispositif d'asservissement de fréquence 1 selon la technique antérieure très connu de l'homme du métier. Le dispositif 1 est une boucle de verrouillage de phase comprenant un comparateur de phase 10, un filtre 11, un oscillateur commandé en tension 12 et un diviseur de fréquence par N 13. Le comparateur 10, le filtre 11 et l'oscillateur 12 sont connectés en cascade selon cet ordre. Une sortie de l'oscillateur 12 est rebouclée sur une première entrée 10₁ du comparateur de phase 10 à travers le diviseur de fréquence 13. Une seconde entrée 10₂ du comparateur de phase 10 reçoit un signal d'horloge pilote Sp à une fréquence pilote fp.

Le fonctionnement du dispositif d'asservissement de fréquence montré à la figure 1 est le suivant.

Le comparateur de phase 10 compare la phase du signal d'horloge pilote Sp avec la phase d'un signal d'horloge d'asservissement Sa produit en sortie du diviseur de fréquence 13, et fournit une tension de commande Vc pour commander l'oscillateur 12 à travers le filtre 11. Le signal d'horloge d'asservissement Sa a une fréquence fa N fois plus petite que la fréquence f1 du signal d'horloge local S1 en sortie de l'oscillateur 12, et sensiblement égale à la fréquence fp du signal d'horloge pilote Sp.

Un tel dispositif est connu de DE-A-24 56 742.

Le dispositif 1 selon la technique antérieure est typiquement utilisé lorsque le rapport de fréquence fl/fp entre la fréquence fl du signal d'horloge local Sl et la fréquence fp du signal d'horloge pilote Sp est inférieur à une valeur sensiblement égale à 10⁴. Il est à noter que, si la fréquence fp du signal d'horloge Sp est très faible, c'est-à-dire si la période du signal Sp est très élevée, le dispositif 1 ne peut être utilisé en raison de difficultés de fabrication du filtre 11 dont les composants doivent avoir des valeurs élevées pour filtrer le signal de commande Vc tout en garantissant une commande précise de l'oscillateur 12.

Si le rapport de fréquence fl/fp est supérieur à une valeur sensiblement égale à 10⁴, le dispositif 1 ne peut être utilisé. En effet, une augmentation ou diminution infime de la fréquence fl du signal Sl produit par l'oscillateur n'induit qu'une très faible variation de phase du signal d'asservissement Sa compte tenu du rapport des périodes entre les signaux Sa et Sl, et le dispositif manque alors de précision.

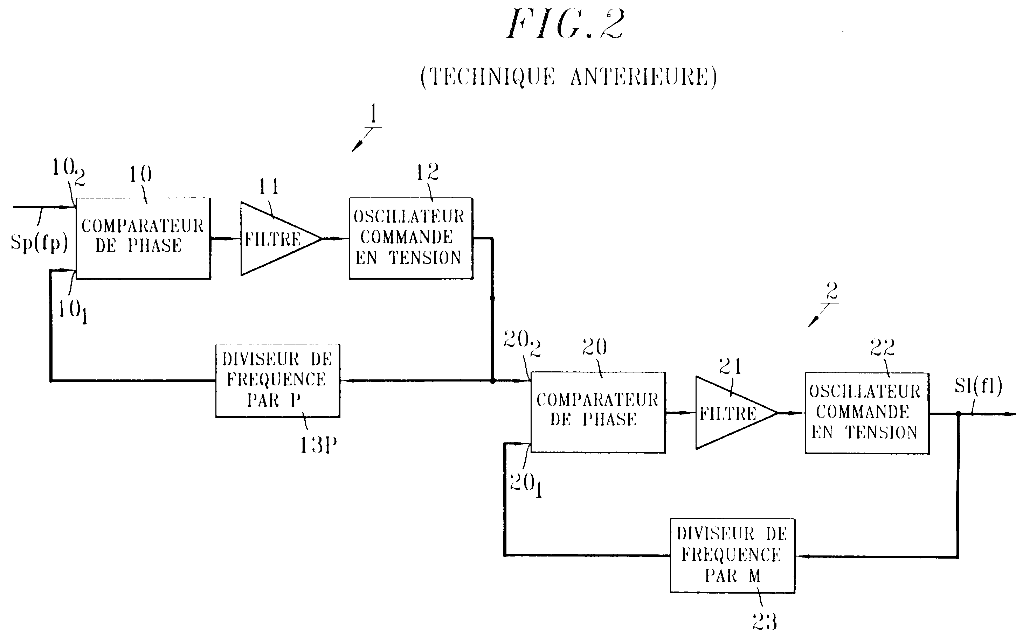

En pratique, quand le rapport de fréquence fl/fp est élevé, typiquement supérieur à 10⁴, la technique antérieure prévoit deux dispositifs d'asservissement de fréquence 1 et 2 qui sont du type montré à la figure 1 et connectés en cascade. Dans cette réalisation montrée sous forme de bloc-diagramme à la figure 2, chacun des premier et second dispositif d'asservissement de fréquence est une boucle de verrouillage de phase, comprenant un comparateur de phase 10, 20, un filtre 11, 21, un oscillateur commandé en tension 12, 22 et un diviseur de fréquence 13P, 23 agencés de la même manière que dans la figure 1. La sortie de l'oscillateur 12 dans le premier dispositif d'asservissement 1 est appliquée à une seconde entrée 20₂ du comparateur de phase 20 dans le second dispositif d'asservissement 2. Les deux dispositifs d'asservissement de fréquence 1 et 2 connectés en cascade confère un facteur de multiplication de fréquence égal à N = (P x M), correspondant à la multiplication de deux rapports de division de fréquence P et M dans les diviseurs de fréquence 13P et 23. Le second oscillateur 22 produit un signal d'horloge local Sl ayant une fréquence N = (P x M) fois plus élevée que la fréquence fp du signal d'horloge pilote Sp appliqué à la seconde entrée 10₂ du comparateur de phase 10.

Cette réalisation résout le problème énoncé précédemment relatif à un rapport de multiplication trop élevé entre la fréquence fp d'un signal d'horloge pilote Sp reçu et la fréquence fl d'un signal d'horloge local Sl à générer.

Cependant, les deux réalisations connues présentent les inconvénients suivants.

Pour des applications dans lesquelles le rapport de fréquence entre la fréquence fl du signal d'horloge local Sl et la fréquence fp du signal d'horloge pilote Sp est très élevée, typiquement supérieur à 10⁴, le dispositif 1 ne peut être utilisé. La réalisation de la figure 2 induit le doublement des composants électroniques puisque deux boucles de verrouillage de phase sont utilisées, et donc une augmentation de coût.

L'invention vise à remédier aux inconvénients précités en fournissant un dispositif d'asservissement de fréquence, qui est destiné à des réalisations pour lesquelles le rapport des fréquences entre la fréquence du signal d'horloge local et la fréquence du signal d'horloge pilote est élevé, et qui est de moindre coût comparativement à la réalisation connue selon la technique antérieure montrée à la figure 2.

A cette fin, un dispositif pour asservir une fréquence locale d'un signal d'horloge local à N fois une fréquence pilote d'un signal d'horloge pilote, N étant un entier prédéterminé,
comprenant, sous la forme d'une boucle de verrouillage de phase, des moyens de comparaison de phase ayant des première et seconde entrées et produisant un signal de commande, des moyens de filtrage pour filtrer le signal de commande, des moyens d'oscillation commandés par le signal de commande filtré pour produire ledit signal d'horloge local, et des premiers moyens de division de fréquence par M recevant ledit signal d'horloge local, M étant un entier prédéterminé inférieur à N, pour diviser ladite fréquence locale en une fréquence intermédiaire d'un premier signal d'asservissement appliqué à la première entrée desdits moyens de comparaison de phase,
est caractérisé en ce qu'il comprend des seconds moyens de division de fréquence par M recevant ledit signal d'horloge local et réinitialisés périodiquement à ladite fréquence pilote par le signal d'horloge pilote pour diviser ladite fréquence locale en la fréquence intermédiaire d'un second signal d'asservissement appliqué à la seconde entrée desdits moyens de comparaison de phase qui comparent des phases respectives desdits premier et second signaux d'asservissement pour produire ledit signal de commande.

La réinitialisation périodique des seconds moyens de diviseur de fréquence impose une référence de phase au second signal d'asservissement en dépendance de la fréquence du signal d'horloge pilote, et permet ainsi l'asservissement en fréquence du signal d'horloge local sur le signal d'horloge pilote.

Selon des réalisations pratiques, les premiers et seconds moyens de division de fréquence incluent chacun un compteur modulo M, de préférence programmable, incrémenté par ledit signal d'horloge local.

Selon un autre objectif de l'invention, le dispositif comprend des moyens additionneurs interconnectés entre les premier et second moyens de division de fréquence afin de stabiliser rapidement le signal d'horloge local lors d'une mise sous tension du dispositif ou après une interruption du signal d'horloge pilote. Les moyens additionneurs peuvent être des moyens pour additionner un mot binaire prédéterminé à des éléments binaires mémorisés respectivement dans des étages binaires de poids forts du compteur inclus dans lesdits seconds moyens de division de fréquence en un résultat binaire, de manière à charger des étages binaires de poids fort dudit compteur inclus dans lesdits premiers moyens de division de fréquence avec ledit résultat binaire, en réponse à une initialisation générale du dispositif et périodiquement à ladite fréquence pilote du signal d'horloge pilote.

D'autres caractéristiques et avantages de la présente invention apparaîtront plus clairement à la lecture de la description suivante en référence aux dessins annexés correspondants dans lesquels :
- la figure 1, déjà commentée, est un bloc-diagramme d'un dispositif d'asservissement de fréquence selon la technique antérieure ;
- la figure 2, commentée également, est un bloc-diagramme d'un dispositif d'asservissement de fréquence selon la technique antérieure résultant de la mise en cascade de deux dispositifs d'asservissement de fréquence du type montré à la figure 1 ; et
- la figure 3 est un bloc-diagramme d'un dispositif d'asservissement de fréquence selon l'invention.

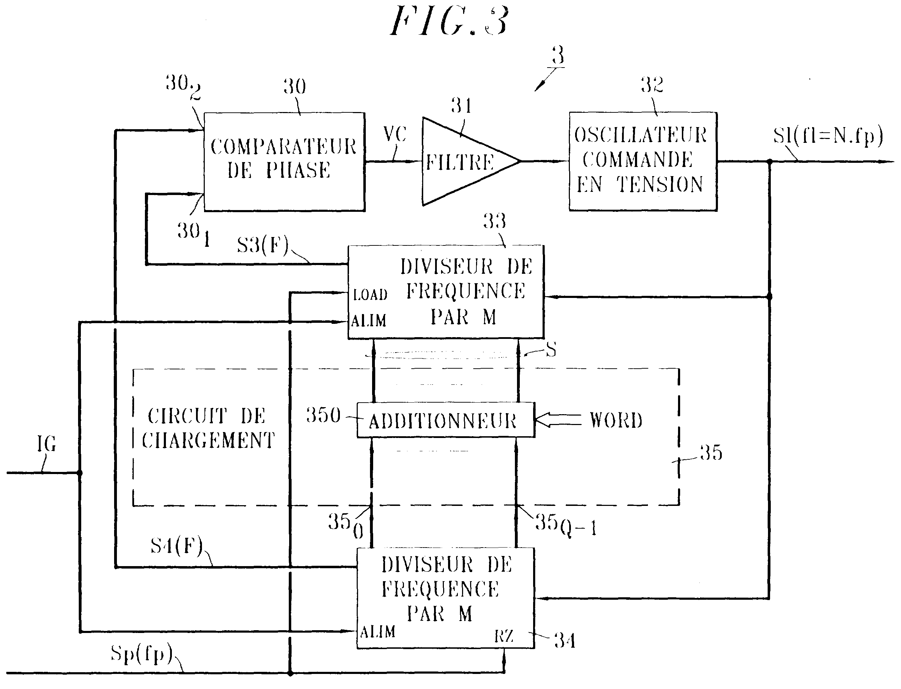

En référence à la figure 3, un dispositif d'asservissement de fréquence 3 selon l'invention pour asservir la fréquence fl d'un signal d'horloge local Sl à N fois la fréquence fp d'un signal d'horloge pilote Sp comprend un comparateur de phase 30, un filtre 31, un oscillateur commandé en tension 32, des premier et second diviseurs de fréquence par M 33 et 34, M étant un entier prédéterminé inférieur à N, et un circuit de chargement 35. A titre d'exemple, les fréquences fp et fl sont 40,96 Hz et 12,288 MHz, l'entier N est 300.000, et l'entier M est 4096.

Le comparateur de phase 30, le filtre 31 et l'oscillateur 32 sont connectés en cascade selon cet ordre. Une sortie de l'oscillateur 32 est reliée à des entrées respectives des diviseurs de fréquence 33 et 34 réalisés chacun sous la forme d'un compteur modulo M de préférence programmable. Des sorties des diviseurs 33 et 34 sont rebouclées sur des première et seconde entrées 30₁ et 30₂ du comparateur de phase 30. Le second diviseur de fréquence 34 reçoit à une entrée de réinitialisation RZ le signal d'horloge pilote Sp, une "réinitialisation" du diviseur 34 correspondant à une remise à zéro (RZ) du compteur d'impulsions du signal fl formant le diviseur 34. Le circuit de chargement 35 a Q entrées parallèles 35₀ à 35_{Q-1} connectées respectivement à Q étages de poids forts du compteur inclus dans le diviseur de fréquence 34, et Q sorties appliquées à Q étages de poids forts du compteur inclus dans le diviseur de fréquence 33.

Le fonctionnement du dispositif d'asservissement de fréquence 3 selon l'invention est le suivant.

Les deux diviseurs de fréquence 33 et 34 ont pour objet d'établir respectivement des signaux d'horloge d'asservissement S3 et S4 à une fréquence intermédiaire F qui est inférieure à et sous-multiple de la fréquence fl du signal d'horloge local Sl à générer mais qui est supérieure à et multiple de la fréquence fp du signal d'horloge pilote Sp. Le diviseur de fréquence par M 34 est réinitialisé, à la fréquence pilote fp, par des fronts montants du signal d'horloge pilote Sp. En raison de cette réinitialisation périodique, une référence de phase du signal d'horloge d'asservissement S4 est maintenue dans le temps en dépendance du signal Sp, ce qui autorise l'asservissement en fréquence. Si cette réinitialisation n'était pas opérée, un glissement des instants de phase significatifs des signaux S3 et S4 par rapport au signal de réinitialisation Sp se produirait au cours du temps en dépendance du glissement de fréquence permanent du signal d'horloge local Sl produit par l'oscillateur 32 autour de la fréquence (N x fp), et l'asservissement en fréquence ne pourrait être obtenu. Il est à noter que la fréquence F des signaux S3 et S4 doit être multiple de la fréquence pilote fp, à une variation près de la fréquence du signal Sl produit par l'oscillateur 32 autour de la fréquence de maintien (Nxfp), pour éviter des sauts de phase périodiques dans le signal S4 à la fréquence du signal d'horloge pilote Sp par rapport au signal S3 en raison de la réinitialisation périodique du diviseur 34 par le signal Sp.

Le comparateur de phase 30 compare la phase du signal S3 à la phase du signal S4, qui est constante en moyenne dans le temps grâce à la réinitialisation périodique du diviseur 34 par le signal Sp. Le comparateur de phase 30 produit une tension de commande VC commandant l'oscillateur 32 à travers le filtre 31. L'oscillateur 32 produit le signal d'horloge local Sl pour que le signal d'horloge d'asservissement S3 soit asservi en phase au signal S4. Cet asservissement de phase assure que, d'une part, la fréquence locale fl est égale à N fois la fréquence pilote fp, et, d'autre part, la phase du signal d'horloge local Sl coïncide périodiquement, à la fréquence locale fp, avec la phase du signal pilote Sp à un déphasage près.

Le fonctionnement de la réalisation telle que décrite ci-dessus sans le circuit de chargement 35 fait abstraction du fait que suite à une initialisation générale IG du dispositif d'asservissement 3, c'est-à-dire une mise sous tension du dispositif, la phase d'un premier front montant du signal d'asservissement S4, dépendant d'un instant de réinitialisation du diviseur de fréquence 34 par le signal d'horloge pilote Sp, peut être très différente (déphasage sensiblement égal à 0 ou π pour un comparateur de phase sous la forme d'une porte OU EXCLUSIF) de la phase d'un premier front montant du signal d'asservissement S3 dépendant de l'instant d'initialisation générale du dispositif. Cela conduit alors à un temps de convergence relativement élevé pour l'asservissement de la fréquence locale fl à N fois la fréquence pilote fp dû aux oscillations de la fréquence du signal Sl autour de la fréquence (N x fp).

Le circuit de chargement 35 est destiné à remédier à cet inconvénient. Ce circuit 35 comprend un additionneur 350. Les sorties des étages de poids forts du compteur inclus dans le diviseur 34 sont appliquées respectivement à des premières entrées parallèles de l'additionneur 350. Des secondes entrées parallèles de l'additionneur 350 reçoivent un mot binaire prédéterminé WORD d'une mémoire morte câblée. Q sorties parallèles S de l'additionneur 350 sont appliquées respectivement à Q étages de poids forts du compteur inclus dans le diviseur 33.

En réponse à la mise sous tension du dispositif 3 par le signal d'initialisation générale IG, les compteurs inclus dans les diviseurs 33 et 34 sont initialisés. Les éléments binaires mémorisés dans les Q étages de poids forts du compteur inclus dans le diviseur 34 sont appliquées aux premières entrées de l'additionneur 350. L'additionneur 350 additionne ces valeurs binaires au mot prédéterminé WORD et le résultat binaire de cette addition est chargé dans les Q étages de poids forts du compteur inclus dans le diviseur 33.

Une initialisation générale IG du dispositif d'asservissement 3 est suivie par un chargement des éléments binaires mémorisés dans les Q étages binaires de poids forts du compteur inclus dans le diviseur 34, auxquels est additionné le mot WORD, dans les Q étages de poids forts dans le compteur inclus dans le diviseur 33. Ce chargement a pour fonction de produire un déphasage entre les signaux d'asservissement S3 et S4. Ce déphasage est égal au rapport de la différence des valeurs binaires respectives mémorisées dans les étages de poids faibles dans les deux compteurs des diviseurs 33 et 34 sur le nombre d'états de comptage des deux compteurs inclus dans les diviseurs 33 et 34 multiplié par la période 1/F des signaux d'asservissement S3 et S4, de manière à commander l'oscillateur 32 dans sa plage d'acquisition en fréquence en évitant ainsi une oscillation de la fréquence fl produite par l'oscillateur 32 autour de la fréquence (Nxfp). La plage d'acquisition en fréquence de l'oscillateur 32 est définie, en terme de phase, par un déphasage périodique entre les signaux S3 et S4 inférieur à un seuil prédéterminé autour d'un déphasage donné entre ces deux signaux correspondant à un maintien de la fréquence courante. Ce déphasage donné est fonction du type de comparateur de phase utilisé. A titre d'exemple, pour un comparateur sous la forme d'une porte OU EXCLUSIF, cette plage d'acquisition correspond à un déphasage entre les signaux S3 et S4 autour de (π/2). Le mot WORD est donc fonction du déphasage entre les signaux S3 et S4 pour lequel l'oscillateur 32 est commandé afin de maintenir la fréquence courante. Il est fonction du type de comparateur de phase utilisé.

Suite à cette initialisation générale du dispositif 3, chaque front montant du signal pilote Sp qui est appliqué à l'entrée de réinitialisation RZ du compteur inclus dans le diviseur 34 et à une entrée de chargement LOAD du compteur inclus dans le diviseur 33, garantit la mise à zéro du compteur inclus dans le diviseur 34 et le chargement des étages de poids forts du compteur inclus dans le diviseur 33 par le mot WORD additionné aux valeurs mémorisées dans les étages de poids forts du diviseur 34. En fonctionnement normal ces mises à zéro et chargement des compteurs inclus dans les diviseurs 34 et 33 confirment les valeurs binaires mémorisées dans ces compteurs. Par contre, une absence momentanée de réception du signal pilote Sp induisant une incrémentation à fréquence variable des compteurs 34 et 33 en dépendance de la variation de la fréquence fl autour de la fréquence de maintien (N x fp) est corrigée par un front montant du signal pilote Sp succédant à cette absence momentanée de réception par réinitialisation et chargement des compteurs 34 et 33.

L'homme du métier appréciera que contrairement au dispositif de la figure 2, le dispositif d'asservissement 3 selon l'invention n'est pas affecté par un défaut de réception momentané du signal d'horloge pilote Sp. En effet, les deux signaux d'asservissement S3 et S4 continuent d'être produits par les deux diviseurs 33 et 34, et seule une dérive en fréquence du signal d'horloge local Sl se produit alors compte tenu de la perte momentanée de la phase du signal Sp dû à ce défaut de réception momentané. Dans le cas du dispositif de la figure 2, un défaut de réception momentané du signal d'horloge pilote entraîne une perte durable du maintien de la fréquence fl à N fois la fréquence fp.

## Revendications

1. Dispositif (3) pour asservir une fréquence locale (fl) d'un signal d'horloge local (Sl) à N fois une fréquence pilote (fp) d'un signal d'horloge pilote (Sp), N étant un entier prédéterminé,
comprenant, sous la forme d'une boucle de verrouillage de phase, des moyens de comparaison de phase (30) ayant des première et seconde entrées (30₁ et 30₂) et produisant un signal de commande (VC), des moyens de filtrage (31) pour filtrer le signal de commande (VC), des moyens d'oscillation (32) commandés par le signal de commande filtré pour produire ledit signal d'horloge local (Sl), et des premiers moyens de division de fréquence par M (33) recevant ledit signal d'horloge local, M étant un entier prédéterminé inférieur à N, pour diviser ladite fréquence locale (fl) en une fréquence intermédiaire (F) d'un premier signal d'asservissement (S3) appliqué à la première entrée (30₁) desdits moyens de comparaison de phase (100),
caractérisé en ce qu'il comprend des seconds moyens de division de fréquence par M (34) recevant ledit signal d'horloge local et réinitialisés périodiquement à ladite fréquence pilote (fp) par le signal d'horloge pilote (Sp) pour diviser ladite fréquence locale (fl) en la fréquence intermédiaire (F) d'un second signal d'asservissement (S4) appliqué à la seconde entrée (30₂) desdits moyens de comparaison de phase (30) qui comparent des phases respectives desdits premier et second signaux d'asservissement (S3, S4) pour produire ledit signal de commande (VC).

2. Dispositif conforme à la revendication 1, caractérisé en ce que lesdits premiers et seconds moyens de division de fréquence (33, 34) incluent chacun un compteur modulo M, de préférence programmable, incrémenté par ledit signal d'horloge local (Sl).

3. Dispositif conforme à la revendication 2, caractérisé en ce qu'il comprend des moyens (35) pour additionner un mot binaire prédéterminé (WORD) à des éléments binaires mémorisés respectivement dans des étages binaires de poids forts du compteur inclus dans lesdits seconds moyens de division de fréquence (34) en un résultat binaire, de manière à charger des étages binaires de poids fort dudit compteur inclus dans lesdits premiers moyens de division de fréquence (33) avec ledit résultat binaire, en réponse à une initialisation générale du dispositif (3) et périodiquement à ladite fréquence pilote (fp) du signal d'horloge pilote (Sp).

## Patentansprüche

1. Vorrichtung (3) zum Takten einer lokalen Frequenz (f1) eines lokalen Taktsignals (S1) mit dem N-fachen einer Steuerfrequenz (fp) eines Steuertaktsignals (Sp), wobei N eine vorher festgelegte, ganze Zahl ist,
in Form einer Phasenverriegelungsschleife umfassend: Phasenvergleichermittel (30), die über erste und zweite Eingänge (30₁ und 30₂) verfügen und ein Steuersignal (VC) erzeugen, Filtermittel (31), um das Steuersignal (VC) zu filtern, Oszillatormittel (32), die durch das gefilterte Steuersignal gesteuert werden, um das genannte lokale Taktsignal (S1) zu erzeugen, und erste Mittel zum Teilen einer Frequenz durch M (33), die das genannte lokale Taktsignal empfangen, wobei M eine vorher festgelegte ganze Zahl kleiner N ist, um die genannte lokale Frequenz (f1) in eine Zwischenfrequenz (F) eines ersten Triggersignals (S3) zu teilen, das an den ersten Eingang (30₁) der genannten Phasenvergleichermittel (100) angelegt wird,
dadurch gekennzeichnet, dass sie zweite Mittel zur Teilung einer Frequenz durch M (34) enthält, die das genannte lokale Taktsignal empfangen und periodisch mit der genannten Steuerfrequenz (fp) durch das Steuertaktsignal (Sp) reinitialisiert werden, um die genannte lokale Frequenz (f1) in die Zwischenfrequenz (F) eines zweiten Triggersignals (S4) zu teilen, das an den zweiten Eingang (30₂) der genannten Phasenvergleichermittel (30) angelegt wird, die entsprechende Phasen der ersten und zweiten Triggersignale (S3, S4) vergleichen, um das genannte Steuersignal (VC) zu erzeugen.

2. Vorrichtung nach Patentanspruch 1, dadurch gekennzeichnet, dass die genannten ersten und zweiten Frequenzteilermittel (33, 34) jeweils einen vorzugsweise programmierbaren Modulo-M-Zähler enthalten, der durch das genannte lokale Taktsignal (S1) inkrementiert wird.

3. Vorrichtung nach Patentanspruch 2, dadurch gekennzeichnet, dass sie Mittel (35) enthält, um ein vorher festgelegtes Binärwort (WORD) zu Binärelementen zu addieren, die jeweils in Binärstufen hohen Wertes des Zählers gespeichert sind, der sich in den genannten zweiten Frequenzteilermitteln (34) befindet, um ein binäres Ergebnis zu erhalten, um in Reaktion auf eine allgemeine initialisierung der Vorrichtung (3) und periodisch mit der genannten Steuerfrequenz (fp) des Steuertaktsignals (Sp) dieses binäre Ergebnis in Binärstufen hohen Wertes des genannten Zählers, der sich in den genannten ersten Frequenzteilermitteln (33) befindet, zu laden.

## Claims

1. A device (3) for slaving a local frequency (f) of a local clock signal (S1) to N times a master frequency (fp) of a master clock signal (Sp), N being a predetermined integer,
comprising, in the form of a phase-locked loop, phase comparing means (30) having first and second inputs (30₁ and 30₂) and producing a control signal (VC), filtering means (31) for filtering the control signal (VC), oscillator means (32) controlled by the filtered control signal for producing said local clock signal (S1), and first divide-by-M frequency divider means (33) receiving said local clock signal, M being a predetermined integer less than N, for dividing said local frequency (f1) into an intermediate frequency (F) of a first slaving signal (S3) applied to the first input (30₁) of said phase comparing means (100),
characterized in that it comprises second divide-by-M frequency divider means (34) receiving said local clock signal and periodically reset at said master frequency (fp) by the master clock signal (Sp) for dividing said local frequency (f1) into the intermediate frequency (F) of a second slaving signal (S4) applied to the second input (30₂) of said phase comparing means (30) which compare respective phases of said first and second slaving signals (S3, S4) thereby producing said control signal (VC).

2. The device according to the claim 1, characterized in that said first and second frequency divider means (33, 34) each include a modulo-M counter, preferably programmable, incremented by said local clock signal (S1).

3. A device according to the claim 2, characterized in that it comprises means (35) for adding a predetermined binary word (WORD) to binary elements respectively stored in most-significant-bit stages of the counter included in said second frequency divider means (34) into a binary result, thereby loading most-significant-bit stages of said counter included in said first frequency divider means (33) with said binary result, in response to a general initialization of the device (3) and periodically at said master frequency (fp) of the master clock signal (Sp).
